Europäisches Patentamt

European Patent Office

Office européen des brevets

(11) Veröffentlichungsnummer: **0 482 315 A2**

# EUROPÄISCHE PATENTANMELDUNG

(21) Anmeldenummer: **91114327.9**

(51) Int. Cl.5: **H03G 3/00**

(22) Anmeldetag: **27.08.91**

(30) Priorität: **20.10.90 DE 4033407**

(43) Veröffentlichungstag der Anmeldung:
**29.04.92 Patentblatt 92/18**

(84) Benannte Vertragsstaaten:
**DE FR GB IT**

(71) Anmelder: **GRUNDIG E.M.V.**
**Elektro-Mechanische Versuchsanstalt Max**
**Grundig holländ. Stiftung & Co. KG.**
**Kurgartenstrasse 37**
**W-8510 Fürth/Bay.(DE)**

(72) Erfinder: **Fischelmayer, Heinrich, Grundig**
**E.M.V.**
**Max Grundig, holländ. Stiftung & Co KG**
**Kurgartenstrasse 37, D-8510 Fuerth(DE)**

(54) **Einrichtung für Audiogeräte zur elektronischen Einstellung der Betriebsfunktionen mit akustischer Rückmeldung der jeweils aktivierten Einstellfunktion.**

(57) Bei Audiogeräten ist mittels elektronischer Regeleinrichtungen die Einstellung von Betriebswerten wie Klang und Lautstärke nötig. Normalerweise wird dabei mit einer optischen Anzeige die jeweils aktivierte Einstellfunktion rückgemeldet.

Bei Audiogeräten, die in Kraftfahrzeugen eingebaut sind, ist es mit einem Risiko verbunden, zur Einstellung des Audiogerätes den Blick auf dessen Anzeige zu richten, während das Kraftfahrzeug von der Bedienperson gesteuert wird. Erfindungsgemäß werden für die einzelnen Einstellvorgänge charakteristische Töne oder Tonfolgen festgelegt, die bei der Aktivierung der Einstellung des Audiogerätes abgestrahlt werden, so daß ohne Blickkontakt die gewünschte Einstellung möglich ist.

Einstellung der Betriebsfunktionen bei Audiogeräten.

FIG.1

EP 0 482 315 A2

Die Erfindung bezieht sich auf eine Einrichtung für Audiogeräte mit elektronischer Regelung von Betriebsfunktionen wie z. B. der Lautstärke- und Klangregelung. Besonders vorteilhaft ist die erfindungsgemäße Einrichtung bei Autoradios, weil die Bedienung des Audiogerätes ohne Blickkontakt zu diesem möglich ist.

Für Audiogeräte sind Einrichtungen bekannt, die durch Sprachausgabemittel Auskunft über den Betriebszustand des Audiogerätes liefern, z. B. durch die DE-OS 31 01 320 der Anmelderin, bei der die jeweils eingestellte Senderfrequenz akustisch mit Hilfe eines Sprach-Synthesizers ausgebeben wird.

Außerdem ist durch die DE-OS 37 05 554 eine Anordnung für Kommunikationsendgeräte für Sehbehinderte bekannt, bei der durch die Berührung der jeweiligen Taste eine akustische Kennung in Form eines Sprachsignals ausgegeben wird, um so den Benutzer vor Auslösen der Taste zu orientieren, um welche Taste es sich handelt.

Weiterhin sind elektronische Lautstärke- und Klangregler bekannt und z. B. in Audiogeräten der Firmen MAGNAT (Zeitschrift STEREOPLAY 2/1990, S. 36, 37) verwendet. Zur Bedienung von Audiogeräten, besonders solchen mit elektronischer Lautstärke- und Klangeinstellung, die für die Einstellung nur über einen Regler, z. B. eine Wipptaste, verfügen, ist der Blickkontakt der Bedienperson zur Anzeigeeinheit des Audiogerätes nötig, um zu erkennen, welche Funktion zur Einstellung vorgewählt und damit einstellbar ist. Ist das Audiogerät jedoch in ein Kraftfahrzeug eingebaut, so entsteht durch das Abwenden des Blickes des Fahrers vom Verkehrsgeschehen, falls er eine Einstellung vornehmen will, eine Gefahrensituation.

Der Erfindung liegt daher die Aufgabe zugrunde, für Audiogeräte mit elektronischer Regelung von Betriebsfunktionen, wie z. B. Lautstärke- und Klangregelung, eine Einrichtung zu schaffen, die es mit geringem Aufwand erlaubt, die Einstellung eines Audiogerätes ohne Blickkontakt zur Anzeigeeinheit desselben vorzunehmen.

Diese Aufgabe ist durch die Erfindung gelöst, wie sie im kennzeichnenden Teil des ersten Patentanspruchs dargestellt ist. Weitere vorteilhafte Ausbildungen der Erfindung sind Gegenstand der Unteransprüche.

Der Vorteil der Erfindung ist darin zu sehen, daß durch die akustische Rückmeldung der jeweils aktivierten Einstellung kein Blickkontakt der Bedienperson zur Anzeigeeinheit des Audiogerätes nötig ist. Dadurch ist die Bedienperson, falls es sich um den Führer eines Kraftfahrzeuges handelt, wesentlich weniger vom Verkehrsgeschehen abgelenkt, woraus sichereres Fahrverhalten resultiert. Ein weiterer Vorteil der Erfindung ist die Verwendung kennzeichnender Töne anstelle eines Sprach-Synthesizers, wodurch der Aufwand sehr gering gehalten werden kann.

Im folgenden wird die Erfindung anhand der Darstellung der Bedienungseinrichtungen eines Audiogerätes näher erläutert. Die Beschreibung geht dabei von der Anwendung der Einrichtung in einem Audiogerät für Kraftfahrzeuge aus. Indessen ist die Erfindung auch für andere Geräte der Unterhaltungselektronik verwendbar.

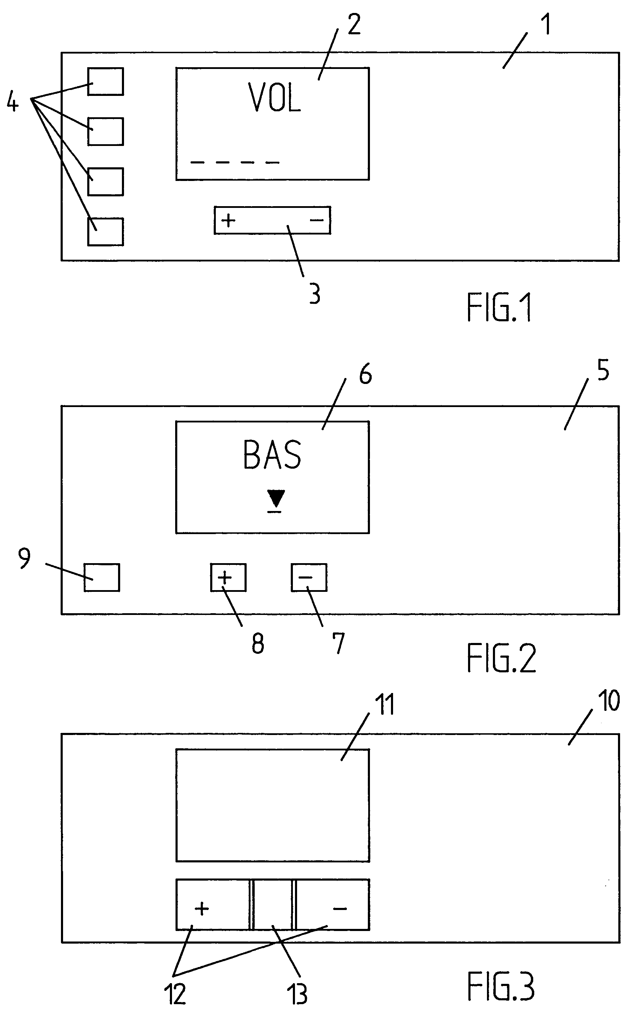

Die Figuren 1 bis 3 zeigen die Stirnseiten von Audiogeräten für den Einbau in Kraftfahrzeuge, wobei nur die Mittel zur elektronischen Lautstärke- und Klangeinstellung, sowie die Anzeigeeinheit wiedergegeben sind.

Figur 1 zeigt beispielsweise die Einstellung der Lautstärke eines Audiogerätes 1. Mit der entsprechenden Auswahltaste 4 wird die Lautstärkeeinstellung ausgewählt und mit der Wipptaste 3 erfolgt die eigentliche Einstellung der Lautstärke. Dabei wird beim Betätigen der entsprechenden Auswahltaste 4 ein die Lautstärkeeinstellung kennzeichnender kurzzeitiger Tonimpuls abgegeben, der jeweils beim Betätigen der Wipptaste 3 wiederholt werden kann. Dadurch ist die Bedienperson des Gerätes informiert, welche Einstellung vorgenommen werden kann, ohne die Anzeigeeinrichtung 2 des Audiogerätes 1 betrachten zu müssen.

In Figur 2 ist die Einstellung des Basses für ein Audiogerät 5 dargestellt. Mit Hilfe der Auswahltaste 9 wird das gewünschte Klangcharakteristikum ausgewählt, wobei die verschiedenen Klangcharakteristika in einer bestimmten Reihenfolge nacheinander durch wiederholtes Betätigen der Auswahltaste 9 ausgewählt werden können. Die eigentliche Einstellung erfolgt dann mit den Tasten 7 und 8. Die Rückmeldung mit einem Tonsignal erfolgt wie oben beschrieben.

In Figur 3 ist ein Audiogerät 10 mit Anzeigeeinheit 11 und eine bevorzugte Ausgestaltungsform des Betätigungselements für Auswahl und Einstellung der Betriebsfunktionen gezeigt. Das Betätigungselement besteht aus einer Wipptaste 12 zum Einstellen der aktuellen Betriebsfunktion und einer Taste 13 in der Mitte der Wipptaste 12, mit der die aktuelle Betriebsfunktion ausgewählt werden kann. Das Betätigungselement, bestehend aus Wipptaste 12 und Taste 13, ist dabei so ausgeführt, daß es ertastbar ist und somit ohne Blickkontakt aufgefunden werden kann. Dies ist z. B. durch Druckmulden oder besondere plastische Hervorhebung der Betätigungselemente zu erreichen. Durch die besondere Anordnung der Betätigungselemente ist außerdem die Bedienung mit einer Hand möglich, wenn z. B. Zeige- und Ringfinger die Wipptaste 12 betätigen und der Mittelfinger die Auswahltaste 13. Die Vorgehensweise bei der Einstellung und die Rückmeldung mit den entsprechenden Tonsignalen erfolgt wie für die Figuren 1 und 2 beschrieben.

Die von der Einrichtung erzeugten kennzeichnenden Tonsignale werden vorteilhaft vom Audiogerät als kurzzeitige Tonsignale abgestrahlt, die sich durch ihre Frequenz unterscheiden, wobei zwischen den einzelnen Tonsignalfrequenzen nichtäquidistante Frequenzschritte liegen, um eine bessere Unterscheidbarkeit zu erzielen. In einer weiteren Ausbildung des Erfindungsgedankens wird als Unterscheidungskriterium eine Folge kurzzeitiger Tonsignale nach Art von Morsezeichen erzeugt.

**Patentansprüche**

1. Einrichtung für Audiogeräte zur elektronischen Einstellung der Betriebsfunktionen mit akustischer Rückmeldung der jeweils aktivierten Einstellfunktion, mit
   - Tasten (4, 9, 13) für die Auswahl der zu aktivierenden Einstellfunktion und
   - einem Betätigungselement (3, 7, 8, 12) zum Einstellen der jeweils aktivierten Betriebsfunktion,
   **dadurch gekennzeichnet, daß**
   - die Einrichtung bei der Aktivierung und/oder Einstellung der jeweiligen Betriebsfunktion unterschiedliche Tonsignale erzeugt,
   - die Einrichtung die Tonsignale an die Verstärkereinheit des mit ihr verbundenen Audiogerätes weitergibt, welche die erzeugten Tonsignale verstärkt,
   - die von der Einrichtung erzeugten und von der Verstärktereinheit verstärkten Tonsignale von den Lautsprechern des Audiogerätes abgestrahlt werden, wodurch die Rückmeldung der aktivierten oder eingestellten Betriebsfunktion erfolgt.

2. Einrichtung nach Anspruch 1,
   **dadurch gekennzeichnet,**
   daß die von der Einrichtung erzeugten Tonsignale kurzzeitige Tonimpulse sind.

3. Einrichtung nach einem oder mehreren der vorhergehenden Ansprüche,
   **dadurch gekennzeichnet,**
   daß die Einrichtung zwei zeitlich unterschiedlich lange Tonsignale nach Art der Morsezeichen erzeugt und durch verschiedene Kombinationen der beiden Tonsignale die jeweilige Betriebsfunktion charakterisiert.

4. Einrichtung nach Anspruch 1 und 2,
   **dadurch gekennzeichnet,**
   daß die Einrichtung den jeweiligen Betriebsfunktionen charakteristische Tonsignale zuordnet, die sich durch ihre Frequenz unterscheiden.

5. Einrichtung nach Anspruch 4,
   **dadurch gekennzeichnet,**
   daß die Einrichtung Tonsignale unterschiedlicher Frequenzen erzeugt, wobei die zu unterscheidenden Tonsignale durch nichtäquidistante Frequenzschritte voneinander getrennt sind.

6. Einrichtung nach einem oder mehreren der vorhergehenden Ansprüche,
   **dadurch gekennzeichnet,**
   daß die Einrichtung eine logische Zuordnung der charakteristischen Tonsignale zu den Betriebsfunktionen derart vornimmt, daß zur Betriebsfunktion Bässe ein tieffrequentes Tonsignal und zur Betriebsfunktion Höhen ein hochfrequentes Tonsignal erzeugt wird.

7. Einrichtung nach einem oder mehreren der vorhergehenden Ansprüche,
   **dadurch gekennzeichnet,**
   daß die Einrichtung die Lautstärke der Tonsignale abhängig von der eingestellten Lautstärke des Audiogerätes festlegt.

FIG.1

FIG.2

FIG.3